# EUROPÄISCHE PATENTSCHRIFT

(11) **EP 2 181 231 B1**
(45) Veröffentlichungstag und Bekanntmachung des Hinweises auf die Patenterteilung: **07.03.2012**
(21) Anmeldenummer: 08748960.5
(22) Anmeldetag: 11.04.2008
(51) Int. Cl.: E05B 65/20

(54) **VORRICHTUNG ZUM AUSLÖSEN VON FUNKTIONEN IN EINEM FAHRZEUG**
DEVICE FOR TRIGGERING FUNCTIONS IN A VEHICLE
DISPOSITIF DE DÉCLENCHEMENT DE FONCTIONS DANS UN VÉHICULE

(30) Priorität: 22.06.2007 DE 102007028898
(43) Veröffentlichungstag der Anmeldung: 05.05.2010
(73) Patentinhaber: Huf Hülsbeck & Fürst GmbH & Co. KG, 42551 Velbert (DE)
(72) Erfinder: WITTE, Martin, 48683 Ahaus (DE); MUELLER, Dirk, 45359 Essen (DE); PESCHL, Andreas, 42549 Velbert (DE)
(74) Vertreter: Patentanwälte Buse, Mentzel, Ludewig
(86) Internationale Anmeldenummer: PCT/EP2008/003083
(87) Internationale Veröffentlichungsnummer: WO 2009/000355

(56) Entgegenhaltungen:
- DE-A1- 10 212 768
- DE-A1- 10 221 511
- DE-A1-102004 019 571
- DE-A1-102005 046 542

## Beschreibung

Die Erfindung richtet sich auf eine Vorrichtung der im Oberbegriff des Anspruches 1 angegebenen Art. Der Näherungssensor und der Drucksensor arbeiten zusammen. Die von ihnen kommenden Signale werden in einem Steuergerät gemeinsam ausgewertet und führen zu einem gemeinsamen Ausgangssignal, welches zur Steuerung der gewünschten Funktionen im Fahrzeug dient.

Die DE 10 2004 019 571 A1 zeigt eine bekannte Vorrichtung dieser Art. Als Druckmessglied fungiert hier ein Piezoelement, welches der Angriffsstelle der Handhabe unmittelbar zugekehrt ist, um im Betätigungsfall von einem an der Angriffsstelle vorgesehenen Zapfen druckbeaufschlagt zu werden. Dieses Piezoelement wird von einer Elektrode getragen, die gegenüber der äußeren Angriffsstelle vom Betätiger weggerichtet ist. Durch das aufliegende Piezoelement wird der Aufbau des elektrischen Feldes vom Näherungssensor beeinträchtigt.

Die DE 10 2005 046 542 A1 zeigt eine Vorrichtung, wo ein Piezoelement als Dielektrikum zwischen zwei Elektroden des Näherungssensors angeordnet ist. Hier schirmen die Elektroden das Piezoelement gegenüber der äußeren Angriffsstelle am Betätiger ab. Dadurch ist eine störungsfreie Arbeitsweise des Piezoelements nicht mehr gewährleistet.

Der Erfindung liegt die Aufgabe zugrunde, eine zuverlässige Vorrichtung der im Oberbegriff des Anspruches 1 angegebenen Art zu entwickeln, die raumsparend ist und bei der sich die Wirkungen des Näherungs- und Drucksensors nicht gegenseitig behindern. Dies wird durch die im Anspruch 1 angeführten Maßnahmen erreicht, denen folgende besondere Bedeutung zukommt.

Obwohl bezüglich der äußeren Angriffsstelle am Betätiger die Elektrode des Näherungssensors fallweise vor dem Druckmessglied des Drucksensors angeordnet sein kann, ist das Druckmessglied nicht abgeschirmt, weil die Elektrode in Ausrichtung mit dem Druckmessglied einen Durchbruch aufweist. Dieser Durchbruch liegt auf der Strecke der Druckübertragung zwischen der äußeren Angriffsstelle des Betätigers und dem Druckmessglied. In diesem Fall ist das Druckmessglied in einer Ebene angeordnet, die - bezogen auf die Angriffsstelle am Betätiger - unterhalb des Durchbruchs angeordnet ist.

Es ist aber auch möglich, das Druckmessglied in der Ebene anzuordnen, in welcher sich die Elektrode mit ihrem Durchbruch befindet. Fallweise könnte die Ebene für das Druckmessglied auch vor dem Durchbruch der Elektrode liegen. In beiden Fällen umschließt die Elektrode rahmenförmig das in Ausrichtung mit ihrem Durchbruch positionierte Druckmessglied. Eine Druckausübung im Bereich der Angriffsstelle des Betätigers gelangt so großflächig durch den Durchbruch hindurch bis zum Druckmessglied.

Das Druckübertragungsmittel kann körperlich ausgebildet sein und z. B. aus einem Stößel bestehen. In diesem Fall ist der Stößel mit seinem einen Ende im Bereich der Angriffsstelle des Betätigers positioniert, z. B. an der Innenwand des Betätigers, während sein Wirkende durch den Durchbruch hindurch auf das Druckmessglied hin gerichtet ist. Für eine durch Fokussierung erzielte Verstärkung der Druckübertragung empfiehlt es sich, einen solchen Stößel als Konus auszubilden, dessen großflächige Basisfläche der Angriffsstelle zugekehrt ist, während sein verjüngtes Ende zum Druckmessglied hin gerichtet ist.

Alternativ oder zusätzlich zu den vorgenannten Druckübertragungsmitteln kann dafür auch ein Medium vorgesehen sein, welches den Raum zwischen der Angriffsstelle, dem Durchbruch in der Elektrode und dem Druckmessglied ausfüllt. Ein solches Medium kann in sich elastisch nachgiebig sein. Für eine gute Weiterleitung des Druckes empfiehlt es sich, das Medium in sich inkompressibel auszubilden. Besonders einfach ist es, als Medium eine Vergussmasse zu verwenden, welche ganz oder teilweise die Aufnahme im Betätiger ausfüllt.

Die Maßnahmen der Erfindung bewirken, dass sowohl die Wirkung der Elektrode nach außen nicht durch das Druckmessglied abgeschirmt ist und dass das Druckmessglied seinerseits über den Durchbruch in der Elektrode unmittelbar mit dem Druck-Übertragungs-Pfad bis zur äußeren Angriffsstelle des Betätigers in Wirkverbindung steht. Weil der Durchbruch für die Druckübertragung genutzt wird, beeinträchtigt umgekehrt auch die Elektrode die Wirkungsweise des Druckmessglieds nicht.

Ein wichtiges Anwendungsfeld der Erfindung ist die Handhabe für eine Tür eines Fahrzeugs. Die in Ansprüche 13-15 erwähnte Aufnahme besteht dabei aus einem Sackloch in der Handhabe, dessen Sackloch-Öffnung dem einen Ende der Handhabe zugekehrt ist. In diese Aufnahme bzw. das Sackloch soll ein Einsatz eingefügt werden können. Im Falle eines Sacklochs wird der Einsatz durch die Sackloch-Öffnung ins Innere der Handhabe eingeschoben. Die Öffnung wird dann durch einen Stopfen mindestens teilweise verschlossen, wobei der Umfang des Stopfens sich wenigstens stellenweise an der Innenfläche der Aufnahme abstützt.

Aus Stabilitätsgründen empfiehlt es sich, die Elektrode des Näherungssensors U-förmig auszubilden. Das lässt auch eine einfachere Montage der Erfindung zu. In diesem Fall ist der Durchbruch im U-Mittelsteg der Elektrode angeordnet, während die Schenkelenden der beiden U-Stege sich an einer Trägerwand abstützen. Das Druckmessglied kann dann im U-Innenbereich angeordnet werden. Der U-Mittelsteg der Elektrode ist dann im Abstand zum Druckmessglied angeordnet.

Bewährt hat sich, das Druckmessglied aus einer vormontierten Baueinheit aufzubauen. Diese Baueinheit umfasst eine Leiterfolie, ein Piezoelement und einen Spacer an einer Printplatte. Die Anschlüsse der Leiterfolie und der Printplatte sind über elektrische Kontakte mit den weiteren elektrischen Bauteilen des Drucksensors verbunden. Das Druckmessglied sitzt auf einer Tragplatte. An der Tragplatte sitzen der Drucksensor und/oder die elektrischen Bauelemente. Die Tragplatte mit ihren Elementen ist vorzugsweise auch Bestandteil des erwähnten Einsatzes.

Im Montagefall ist die erwähnte Leiterfolie des Druckmessglieds der Angriffsstelle des Betätigers zugekehrt. Diese Leiterfolie kann Vorteilhaft aus Leiterstäben eines Gitterwerkes aufgebaut sein, wobei das Gitterwerk das bereits erwähnte Piezoelement kontaktiert.

Um die Anzahl der Bauelemente zu verringern, empfiehlt es sich entweder die erwähnte Leiterfolie oder das Gitterwerk der Leiterfolie vom Druckmessglied die weitere Funktion zu geben, eine Elektrode des Näherungssensors zu sein. Dieses Gebilde hat dann eine Doppelfunktion; es ist sowohl Bestandteil des Druckmessglieds als auch des Näherungssensors.

Weitere Maßnahmen und Vorteile der Erfindung ergeben sich aus den weiteren Ansprüche, der Beschreibung und den Zeichnungen. In den Zeichnungen ist ein Ausführungsbeispiel der Erfindung teils schematisch und teils konkret dargestellt. Es zeigen:
- Fig. 1: schematisch, einen Längsschnitt durch einen Betätiger, in welchem die erfindungsgemäße Vorrichtung integriert ist,
- Fig. 2: in starker Vergrößerung einen schematischen Längsschnitt durch das bei der erfindungsgemäßen Vorrichtung verwendete Druckmessglied,
- Fig. 3: ein Teilstück eines konkreten Betätigers, aus welchem ein zur Erfindung gehörender Einsatz teilweise herausgezogen worden ist,
- Fig. 4: ein Teilstück des in Fig. 3 gezeigten Einsatzes vor dessen Einbau im Betätiger von Fig. 3,
- Fig. 5: schematisch, ein Bruchstück einer zu Fig. 1 ersten alternativen Ausführung der erfindungsgemäßen Vorrichtung,
- Fig. 6: eine zweite Alternative dieser Vorrichtung und
- Fig. 7: unter Verwendung des aus Fig. 2 ersichtlichen Aufbaus, eine dritte Alternative der erfindungsgemäßen Vorrichtung.

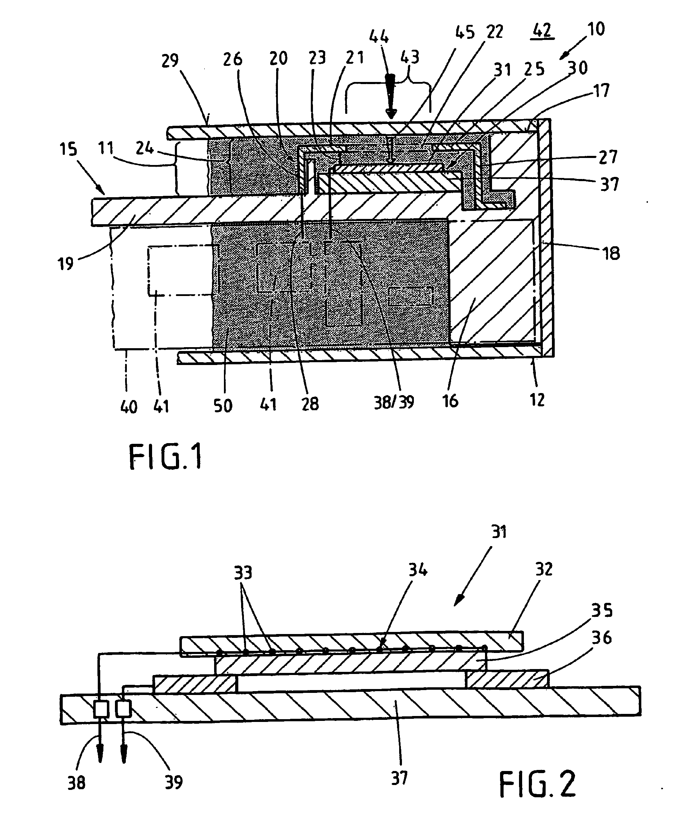

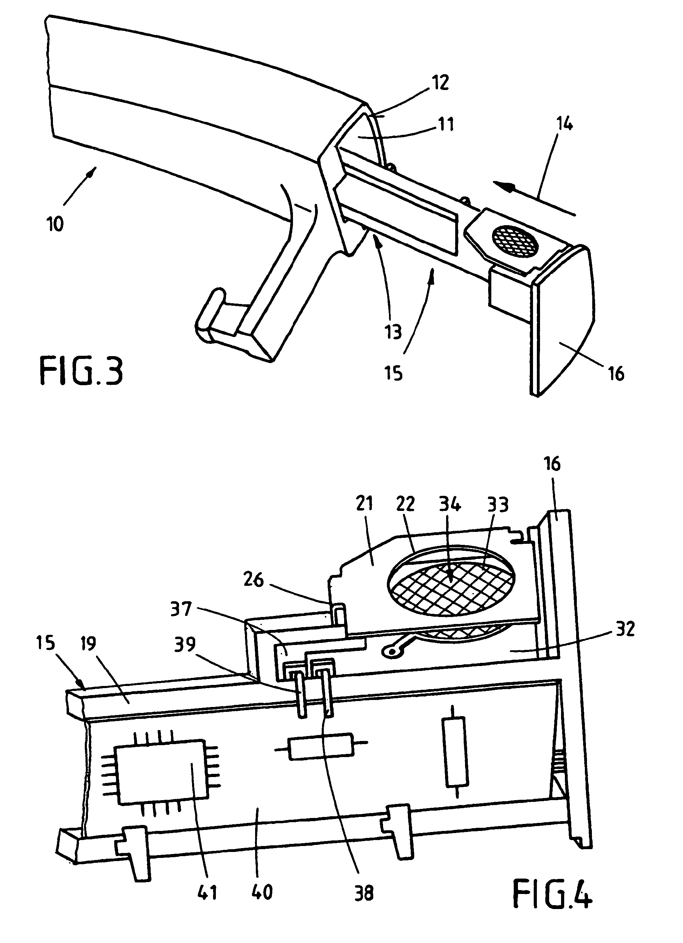

Als Betätiger 10 zum Auslösen von Funktionen in einem Fahrzeug dient im vorliegenden Fall eine Handhabe zum Betätigen eines nicht näher gezeigten Schlosses im Fahrzeug. Der Betätiger 10 besitzt eine Aufnahme 11 z. B. in Form einer Bohrung, deren Öffnung 13 sich an dem einen Ende 12 der Handhabe 10 befindet. Durch diese Öffnung 13 kann ein Einsatz 15 im Sinne des aus Fig. 3 erkennbaren Pfeils 14 in das Innere des Betätigers 10 eingeschoben werden. An seinem Außenende besitzt der Einsatz 15 einen Stopfen 16, der im Einsteckfall, gemäß Fig. 1, die Öffnung der Bohrung 11 verschließt und sich umfangsmäßig an den Innenflächen 17 der Bohrung abstützt. Auf der Außenseite des Stopfens 16 kann noch ein aus Fig. 1 erkennbarer Deckel 18 das Handhaben-Ende 12 abschließen. Ein solcher Deckel 18 sollte materialmäßig und farblich der Außenfläche des Betätigers 10 angepasst sein.

Der Einsatz 15 besitzt eine sich in Verlaufsrichtung der Handhabe erstreckende Tragwand 19. An mindestens einer Seite dieser Tragwand 19 ist eine Platine 40 befestigt, die Leiterbahnen für schematisch angedeutete elektrische Bauteile 41 aufweist. Die Bauteile 41 sind verschiedenen Sensoren 20, 30 und Kommunikationsgeräten für das Fahrzeug zugeordnet. Diese Bauteile haben prinzipiell folgenden Aufbau und nachfolgend beschriebene Wirkungsweise. Auf der gegenüberliegenden Seite der Tragwand 19 kann sich ein zusätzliches kapazitives Element befinden, welches zu einem elektronischen Schließsystem gehören kann.

Der Betätiger 10 ist Bestandteil dieses elektronischen Schließsystems, das z. B. zum Entriegeln und/oder Verriegeln des bereits erwähnten Schlosses an einer Tür oder Klappe des Fahrzeugs dient. Der Betätiger 10 ist dann eine Handhabe der Tür oder Klappe und besteht, wie Fig. 3 bruchstückhaft zeigt, aus einer sogenannten Zieh-Handhabe. Bei einer manuellen Betätigung wird die Handhabe, auch zum mechanischen Öffnen des Schlosses genutzt. Dieses elektronische Schließsystem wird sowohl durch eine Fernwirkung als auch durch eine manuelle Druckbetätigung gesteuert, wofür im Inneren des Betätigers 10 zwei miteinander zusammenwirkende. Sensoren 20, 30 vorgesehen sind. Im vorliegenden Fall dienen die Sensoren 20, 30 zum Verriegeln des Schlosses, während das vorausgehend erwähnte zusätzliche kapazitive Element, das nicht näher gezeigt ist, zum Öffnen des Schließsystems genutzt wird.

Wenn sich eine berechtigte Person dem Fahrzeug nähert bzw. deren Hand in die Nähe des Betätigers 20 gebracht wird, findet zunächst beim sogenannten "keyless entry" eine Prüfung der Zugangsberechtigung statt. Die berechtigte Person ist nämlich im Besitz eines Identifikations-Gebers, der nachfolgend kurz "ID-Geber" genannt werden soll. Im Fahrzeug ist diesem ID-Geber ein damit bereits auf Entfernung in Kommunikation tretender Identifikations-Nehmer zugeordnet, der dementsprechend als "ID-Nehmer" bezeichnet werden soll. Bei Annäherung der berechtigten Person findet somit eine mono- oder bidirektionale Kommunikation zwischen dem ID-Geber und dem ID-Nehmer statt, die im Erfolgsfall die erwähnte Entriegelung oder Verriegelung des Schlosses bewirkt. Im vorliegenden Fall wird diese Kommunikation von einem Näherungssensor 20 ausgelöst, zu welchem mindestens folgende im Inneren des Betätigers 10 befindliche Bauteile gehören.

Der Näherungssensor 20 umfasst eine kapazitive Elektrode 21, die um den Betätiger 10 herum im Außenraum 42 ein elektrisches Feld aufbaut. Wenn die Hand der berechtigten Person in dieses elektrische Feld gelangt, stellen die zum Näherungssensor 20 gehörenden elektrischen Bauteile eine Kapazitäts-Änderung fest, die einem elektrischen Steuergerät gemeldet wird. Wenigstens einige dieser Bauteile des Näherungssensors 20 und des Steuergerätes können ebenfalls im Inneren des Betätigers 10 angeordnet sein. Bei erfolgreicher Kommunikation findet z. B., wie schon gesagt wurde, eine Verriegelung des Schlosses statt.

Nach der manuellen Betätigung erfolgt also innerhalb einer definierten Zeitspanne im vorliegenden Fall ein motorisches Schließen des Schlosses. An der Auslösung der Schließbewegung des Schlosses ist ein Drucksensor 30 beteiligt, von welchem mindestens ein Druckmessglied 31 ebenfalls im Inneren des Betätigers 10 angeordnet ist, und zwar in besonderer Kombination mit der vorerwähnten Elektrode 21 des Näherungssensors 20.

Die Wirkungsweise des Drucksensors 30 wird ausgelöst, wenn an einer bestimmten, in Fig. 1 mit 43 gekennzeichneten Angriffsstelle ein Druck im Sinne des Kraftpfeils 44 ausgeübt wird. Unterhalb dieser Angriffsstelle 43 befindet sich zwar die Elektrode 21 des Näherungssensors 20, doch besitzt die Elektrode 21 an dieser Stelle einen Durchbruch 22. Unter dem Durchbruch 22 ist in Abstand 23 das Druckmessglied 31 des Drucksensors 30 angeordnet. Außerdem ist mindestens der Raum 24 mit einer in sich nachgiebigen Vergussmasse 50 ausgefüllt, die im vorliegenden Fall sogar die ganze Aufnahme 11 ausfüllt. Diese Vergussmasse 50 wird nach dem Einbau des bestückten Einsatzes 15 im Inneren des Betätigers 10 eingefüllt. Die Vergussmasse 50 befindet sich also auf dem durch einen Pfeil 45 markierten Pfad, über welchen ein an der Angriffsstelle 43 ausgeübter Druck 44 durch den Durchbruch 22 in der Elektrode 21 hindurch bis zum Druckmessglied 31 gelangt und dadurch den Drucksensor 30 wirksam setzt.

Wie am besten aus Fig. 1 zu ersehen ist, besteht, im Querschnitt gesehen, die Elektrode 21 vom Näherungssensor 20 beim ersten Ausführungsbeispiel aus einem im Wesentlichen U-förmig abgewinkelten Blechabschnitt. Diese U-Form lässt sich in zwei U-Schenkel 26, 27 gliedern, die durch einen U-Mittelsteg 25 miteinander verbunden sind. Im U-Mittelsteg 25 befindet sich der Durchbruch 22. Die Enden der beiden U-Schenkel 26, 27 stützen sich an der einen Seite der Tragwand 19 vom Einsatz 15 ab, z. B. ist der U-Schenkel 26 durch elektrische Verbindungen 28 mit den Leiterbahnen der Platine 40 und den zugehörigen elektrischen Bauteilen 41 vom Einsatz 15 kontaktiert. Wie Fig. 1 zeigt, befindet sich das dort nur schematisch verdeutlichte Druckmessglied 31 im U-Innenbereich zwischen den beiden Schenkeln 26, 27 und dem U-Mittelsteg 25. Es kann dabei der bereits erwähnte Abstand 23 bestehen. Wie ein solches Druckmessglied 31 aussehen kann, ist aus der Darstellung von Fig.2 ersichtlich.

Das Druckmessglied besteht aus einer mehrere Bauteile umfassenden Baueinheit 31 gemäß Fig. 2. Dazu gehört zunächst eine Leiterfolie 32, die dem Durchbruch 22 der Elektrode 21 zugekehrt ist und daher zuerst die Druckübertragung 45 aufzunehmen hat. Wie konkret in Fig. 4 zu erkennen ist, beinhaltet die Leiterfolie 32 ein Gitterwerk 34 aus elektrisch leitenden Stäben 33, die mit einem unterhalb der Leiterfolie 32 angeordneten Piezoelement 35 kontaktieren. Das Piezoelement 35 sitzt auf einem ringförmigen Spacer 36, der auf der gegenüberliegenden Seite das Piezoelement 35 elektrisch kontaktiert. Diese Bauelemente 32, 35, 36 sind auf einer Tragplatte 37 vormontiert. Von der Tragplatte 37 gehen Kontakte bzw. elektrische Anschlüsse 38, 39 aus, die mit den bereits erwähnten elektrischen Bahnen der Platine 40 verbunden sind. Auch die Tragplatte 37 kann integrierte elektrische Bahnen für den Anschluss des leitenden Gitterwerks 34 und des Spacers 36 besitzen. Die Tragplatte 37 kann daher auch als "Print" bezeichnet werden.

Eine eigenständige erfinderisch Bedeutung haben die in Anspruch 25 erwähnten Maßnahmen, die als Alternative zu den im Anspruch 1 angeführten Maßnahmen zu sehen sind. In diesem Fall wird das Gitterwerk 34 in der Leiterfolie 32 vom Druckmessglied 31 zugleich dazu benutzt, um die Funktionen einer Elektrode eines Näherungssensors zu bewirken. Dazu bedarf es nur einer entsprechenden Aufbereitung der vom Gitterwerk 34 erzeugten elektrischen Feldes, welches auf Annäherung einer Person anspricht. Bei dieser Alternative kann die vorbeschriebene Elektrode 21 mit ihrem Durchbruch 22 wegfallen, weil diese Aufgabe vielmehr bereits von dem Gitterwerk 34 besorgt. Die Maschenöffnungen wirken als eine Vielzahl von Durchbrüchen, welche die Druckbetätigungskräfte auf das Piezoelement 35 gelangen lassen. Das Gitterwerk 34 ist aufgrund seiner geometrischen Struktur auch in sich biegefähig, was die Druckübertragung bis zum Piezoelement 35 begünstigt.

Es versteht sich, dass anstelle eines Gitterwerks 34 auch eine andere Anordnung der maßgeblichen Leiterstäbe 33 in der Leiterfolie 32 erfolgen könnte, nämlich z.B. in Form einer Schar nebeneinander liegender elektrischer Leiter, die auf eine andere Weise als durch sich kreuzende Leiterstäbe miteinander verbunden sind. Dazu eignet sich z.B. eine gewundene Doppelspirale aus elektrischen Leitern, wo die einzelnen Windungen bei einer Dehnung der Leiterfolie 32 bei einer Druckausübung 44 sich ohne Weiteres in ihren radialen Abständen voneinander entfernen können. Das Gitterwerk könnte schließlich auch als Mäander ausgebildet sein.

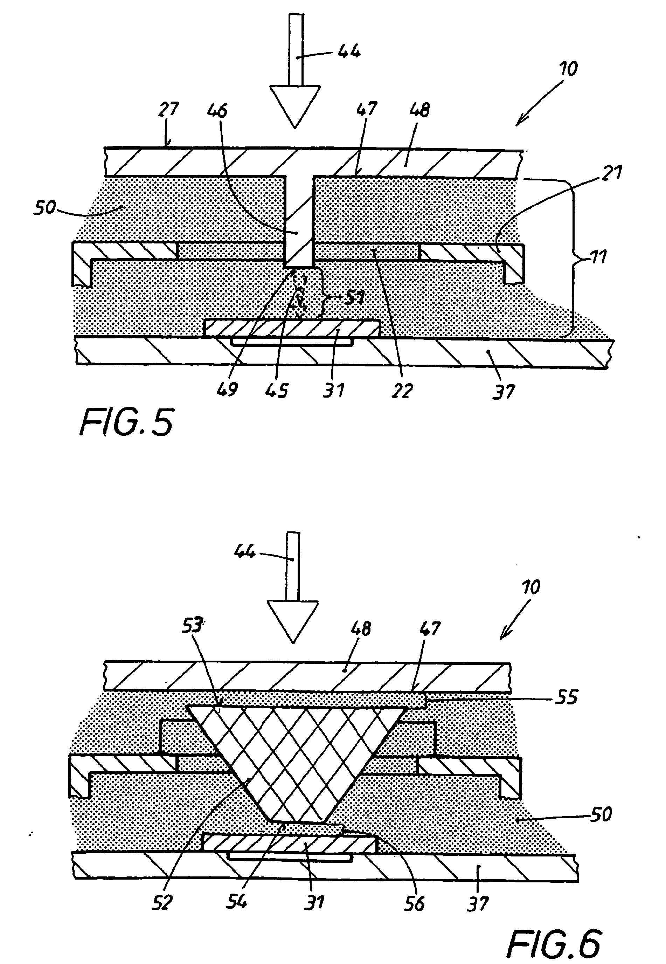

Anstelle der Vergussmasse 50 könnte das Innere 11 des Betätigers 10 auch von anderem Material ausgefüllt sein, z. B. ein Material mit einer Körnerstruktur. Bedeutsam ist, dass eine Druckausübung 44 über den vorbeschriebenen Pfad 45 bis zum Druckmessglied 31 gelangt. Deshalb könnte man im Bereich des Pfades 45 auch massive Elemente anordnen, die den Durchbruch 22 der Elektrode 21 durchgreifen und so für die Druck-Übertragung 45 sorgen. Beispiele dazu sind in den Fig. 5 und 6 schematisch veranschaulicht, woraus sich folgender Aufbau ergibt.

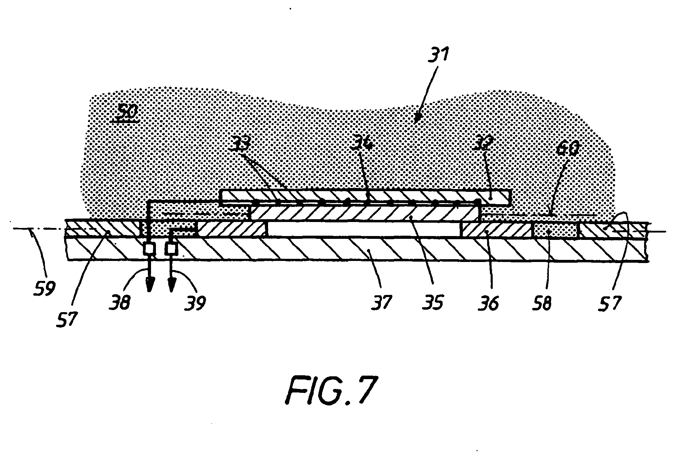

Fig. 5 zeigt schematisch und in Vergrößerung einen oberen Bereich der erfindungsgemäßen Vorrichtung in einer ersten Alternative zu Fig. 1. Die Fig. 6 zeigt den gleichen Bereich in einer zweiten Alternative, während Fig. 7 eine dritte Alternative der Erfindung anhand der Fig. 2 verdeutlicht. Bei diesen alternativen Ausführungen von Fig. 5 bis 7 werden die gleichen Bezugszeichen wie im ersten Ausführungsbeispiel von Fig. 1 und 2 verwendet, weshalb insoweit zunächst die bisherige Beschreibung gilt. Es genügt lediglich die Unterschiede dieser drei Alternativen zum ersten Ausführungsbeispiel von Fig. 1 und 2 zu beschreiben.

In Fig. 5 gibt es zwar auch ein durch Punktschraffur veranschaulichtes Medium in der Aufnahme 11, doch dient als weiteres wesentliches Druckübertragungsmittel ein Stößel 46, der fußseitig an der Innenfläche 47 jener nachgiebigen Wand 48 sitzt, welche die bereits oben erwähnte Außenseite 27 des Betätigers 10 erzeugt. Das freie Arbeitsende 49 des Stößels ist mit dem Druckmessglied 31 ausgerichtet. Der Stößel 46 durchsetzt den Durchbruch 22 der Elektrode 21. Bei einer Druckausübung 44 setzt sich der Druck über den Stößel 46 im Sinne des Druck-Übertragungs-Pfads 45 durch eine mit 51 bezeichnete Schicht des dortigen Mediums 50 fort.

Das zweite Ausführungsbeispiel von Fig. 6 hat einen ähnlichen Aufbau. Hier fungiert ein konisches Element 52 als Stößel. Das Konus-Element 52 ist mit seiner großflächigen Kegelbasis 53 der vorbeschriebenen Innenfläche 47 der Handhabe 10 zugekehrt. Sein verjüngtes Kegelende 54 ist zum Druckmessglied 31 hin gerichtet, das auf einem Träger 37 oder einer Platine ruht. Oberhalb und/oder unterhalb dieses Konuselements 52 können sich Schichten 55, 56 eines auch in diesem Fall vorgesehenen Mediums 50 befinden und dadurch an der Druckübertragung mitwirken. Das Konuselement 52 wirkt bei einer Druckausübung 44 wie ein Druckverstärker, weil es die auf seiner großen Kegelbasis 53 auftreffende Belastung sammelt und konzentriert und deshalb verstärkt an seinem verjüngten Ende 54 auf das Druckmessglied 31 überträgt. Die Vorrichtung von Fig. 6 ist daher besonders gut druckempfänglich und dadurch funktionssicher.

Im dritten Ausführungsbeispiel von Fig. 7 liegen die bereits anhand von Fig. 2 erläuterten Verhältnisse vor. Die Besonderheit liegt darin, dass das Druckmessglied 31 mit seinen diversen Elementen rahmenartig von einer Elektrode 57 eines nicht näher gezeigten Näherungssensors umschlossen wird. Auch in diesem Fall weist also die Elektrode 57 den vorbeschriebenen Durchbruch 58 auf, in welchem das Druckmessglied 31 angeordnet ist. Im vorliegenden Fall ist die Elektrode 57 auf der bereits im Zusammenhang mit Fig. 2 beschriebenen Tragplatte 37 oder einer analogen Platine angeordnet. Die Tragplatte 37 ist daher Träger sowohl der Elektrode 57 als auch des Druckmessglieds 31, ohne dass sich diese beiden Sensoren wechselseitig behindern.

Im dritten Ausführungsbeispiel von Fig. 7 ist das maßgebliche Element des Druckmessglieds 31, nämlich das Piezoelement 35, in der durch Punktschraffur hervorgehobenen Ebene 60 angeordnet. Durch eine Strichpunktlinie 59 ist auch die analoge Ebene der Elektrode 57 in Fig. 7 eingezeichnet. Wie aus dem Vergleich der Ebenen 60, 59 zu entnehmen ist, kann sogar die Ebene 60 des Druckmessglieds etwas vor der Elektrode 57 positioniert sein. Auf die Lage der Ebenen 59, 60 kommt es folglich nicht an, auch wenn ein Aufbau gemäß Fig. 1 bis 6 sich besonders gut bewährt hat.

### Bezugszeichenliste:

- 10: Betätiger, Tür-Handhabe
- 11: Aufnahme, Bohrung
- 12: erstes Ende von 10
- 13: Öffnung von 11
- 14: Pfeil der Einsteckbewegung von 15
- 15: Einsatz
- 16: Stopfen von 15
- 17: Innenfläche von 16
- 18: Deckel für 13 an 15
- 19: Tragwand von 15 für 20, 30, 40
- 20: Näherungssensor
- 21: Elektrode von 20
- 22: Durchbruch in 21
- 23: Abstand zwischen 21, 31 (Fig. 1)
- 24: Raum zwischen 43, 22, 31 (Fig. 1)
- 25: U-Mittelsteg von 21 (Fig. 1)
- 26: erster U-Schenkel von 21 (Fig. 1)
- 27: zweiter U-Schenkel vom 21 (Fig. 1)
- 28: elektrische Verbindung zwischen 26 und 40 (Fig. 1)
- 29: Außenseite von 10 (Fig. 1)
- 30: Drucksensor
- 31: Druckmessglied von 30, Baueinheit
- 32: Leiterfolie von 31 (Fig. 2)
- 33: Leiterstab in 32 (Fig. 2, 3)
- 34: Gitterwerk aus 33 (Fig. 2, 3)
- 35: Piezoelement (Fig. 2)
- 36: Spacer (Fig. 2)
- 37: Tragplatte, Print (Fig. 1 bis 3)
- 38: elektrischer Anschluss für 33, 34 (Fig. 2)
- 39: elektrischer Anschluss für 36 (Fig. 2)
- 40: Platine
- 41: elektrische Bauteile für 20, 30
- 42: Außenraum von 10 für elektrisches Feld
- 43: Angriffsstelle an 10
- 44: Kraftpfeil der Druckausübung auf 43 (Fig. 1)
- 45: Druck-Übertragungs-Pfad (Fig. 1)
- 46: Stößel (Fig. 5)
- 47: Innenfläche von 48 (Fig. 5)
- 48: Wand von 10 (Fig. 5)
- 49: Arbeitsende von 46 (Fig. 5)
- 50: Vergussmasse, Medium (Fig. 1, 5 bis 7)
- 51: Schicht von 50 (Fig. 5)
- 52: konisches Element (Fig. 6)
- 53: Kegelbasis von 52 (Fig. 6)
- 54: verjüngtes Kegelende von 52 (Fig. 6)
- 55: obere Schicht von 50 (Fig. 6)
- 56: untere Schicht von 50 (Fig. 6)
- 57: Elektrode von 20 (Fig. 7)
- 58: Durchbruch von 57 (Fig. 7)
- 59: Ebene von 57 (Fig. 7)
- 60: Ebene von 35 (Fig. 7)

## Patentansprüche

1. Vorrichtung zum Auslösen von Funktionen in einem Fahrzeug,
insbesondere zum Auslösen einer mono- oder bidirektionalen Kommunikation zwischen einem im Besitz einer berechtigten Person befindlichen Identifikations-Geber (ID-Geber) und einem im Fahrzeug angeordneten Identifikations-Nehmer (ID-Nehmer),
die bei Erfolg der Kommunikation die gewünschte Funktion im Fahrzeug bewirken, insbesondere ein Schloss im Fahrzeug entriegeln und/oder verriegeln,
mit einem Betätiger (10) am Fahrzeug, der in seinem Inneren mindestens zwei miteinander kooperierende Sensoren (20, 30) aufweist, nämlich
einerseits einen auf Annäherung einer Person ansprechenden Näherungssensor (20) mit einer kapazitiven Elektrode (21) im Inneren des Betätigers (10), die im Außenraum (42) des Betätigers (10) ein elektrisches Feld aufbaut,
und andererseits einen auf Druckausübung (44) ansprechenden Drucksensor (30), dessen Druckmessglied (31) sich ebenfalls im Inneren des Betätigers (10) befindet,
und mit einer zur manuellen Druckausübung (44) dienenden Angriffsstelle (43) an der Außenseite des Betätigers (10),
**dadurch gekennzeichnet,**
**dass** die Elektrode (21) des Näherungssensors (20) einen Durchbruch (22) aufweist, der zwischen der Angriffsstelle (43) am Betätiger (10) und dem Druckmessglied (31) des Drucksensors (30) angeordnet ist,
und **dass** ein Druckübertragungsmittel (50) eine Druckausübung (44) von der Angriffsstelle (43) durch den Durchbruch (22) in der Elektrode (21) großflächig bis zum Druckmessglied (31) weiterleitet (45).

2. Vorrichtung nach Anspruch 1, **dadurch gekennzeichnet, dass** - bezogen auf die Angriffsstelle (43) am Betätiger (10) - das Druckmessglied (31) in einer Ebene unterhalb des Durchbruchs (22) angeordnet ist
und dass die Druckausübung (44) mittels des Druckübertragungsmittel (50) durch den Durchbruch (22) hindurch bis zum davon entfernt angeordneten Druckmessglied (31) weitergeleitet (45) wird.

3. Vorrichtung nach Anspruch 1, **dadurch gekennzeichnet, dass** das Druckmessglied (31) in der Ebene (60) des in der Elektrode (57) vorgesehenen Durchbruchs (58) oder in einer Ebene (59) vor dem Durchbruch (58) angeordnet ist und über das Druckübertragungsmittel (50) eine Druckbetätigung empfängt.

4. Vorrichtung nach einem der Ansprüche 1 bis 3, **dadurch gekennzeichnet, dass** das Druckübertragungsmittel einen Stößel (46) umfasst.

5. Vorrichtung nach Anspruch 4, **dadurch gekennzeichnet, dass** der Stößel (46) im Bereich der Angriffsstelle (43) an der Innenwand (47) des Betätigers (10) sitzt
und dass der Stößel (46) durch den Durchbruch (22) hindurch auf das Druckmessglied (31) hin gerichtet ist.

6. Vorrichtung nach Anspruch 4 oder 5, **dadurch gekennzeichnet, dass** der Stößel (46) als konisches Element (52) ausgebildet ist, welches mit seiner großflächigen Basis (53) der Angriffsstelle (43) am Betätiger (10) zugekehrt ist und mit seiner konischen Verjüngung (55) zum Druckmessglied (31) hin weist.

7. Vorrichtung nach einem der Ansprüche 1 bis 6, **dadurch gekennzeichnet, dass** das Druck-Übertragungsmittel ein Medium (50) ist, welches den Raum (24) zwischen der Angriffsstelle (43), dem Durchbruch (21) in der Elektrode (20) und dem Druckmessglied (31) ausfüllt.

8. Vorrichtung nach einem der Ansprüche 1 bis 7, **dadurch gekennzeichnet, dass** zu dem Medium (50) auch noch ein weiteres körperliches Übertragungsmittel hinzutritt.

9. Vorrichtung nach Anspruch 7 oder 8, **dadurch gekennzeichnet, dass** das Medium (50) in sich elastisch nachgiebig ist.

10. Vorrichtung nach einem der Ansprüche 7 bis 9, **dadurch gekennzeichnet, dass** das zur Weiterleitung (45) des Drucks (44) dienende Medium (50) im Wesentlichen in sich inkompressibel ist.

11. Vorrichtung nach einem der Ansprüche 7 bis 10, **dadurch gekennzeichnet, dass** das Medium aus einer Vergussmasse (50) besteht.

12. Vorrichtung nach einem der Ansprüche 7 bis 11, **dadurch gekennzeichnet, dass** das Medium oder die Vergussmasse (50) im Wesentlichen die ganze Aufnahme (11) im Inneren des Betätigers (10) ausfüllt und vor eindringenden Umwelteinflüssen, wie Feuchtigkeit, schützt.

13. Vorrichtung nach einem der Ansprüche 1 bis 12, **dadurch gekennzeichnet, dass** das Innere des Betätigers (10) eine Aufnahme (11) für einen Einsatz (15) besitzt, die das Übertragungsmittel aufnimmt oder von dem Medium oder der Vergussmasse (50) umhüllt ist,
und dass der Einsatz (15) mindestens die gelochte (22) Elektrode (21) vom Näherungssensor (20) und das Druckmessglied (31) des Drucksensors (30) trägt.

14. Vorrichtung nach Anspruch 13, **dadurch gekennzeichnet, dass** der Einsatz (15) wenigstens einige elektrische Bauteile (41) für den Betrieb des Näherungssensors (20), des Drucksensors (30) und/oder die Kommunikationsmittel (41) aufnimmt und/oder eine Platine (40) zur Kontaktierung dieser Bauteile (41) und/oder dieser Sensoren (20, 30) beinhaltet.

15. Vorrichtung nach Anspruch 13 oder 14, **dadurch gekennzeichnet, dass** der Einsatz (15) eine Tragwand (19) besitzt, die sich ins Innere der Aufnahme (11) erstreckt und an der Tragwand (19) die beiden Sensoren (20, 30), die elektrischen Bauteile (41) und/oder die Platine (40) sitzen.

## Claims

1. Device for triggering functions in a vehicle,
in particular for triggering a mono-directional or bi-directional communication between an identification encoder (ID-encoder) in the possession of an authorized person and an identification decoder (ID-decoder) arranged in a vehicle,
which upon successful communication actuates the desired function in the vehicle, in particular the unlocking and/or locking of a lock in the vehicle,
with an actuator (10) on the vehicle, said actuator containing at least two mutually interactive sensors (20, 30), namely,
on the one hand a proximity sensor (20)-which reacts to an approaching person-with a capacitive electrode (21) inside the actuator (10) which builds up an electrical field in the surface broaching (42) of the actuator (10),
and on the other hand a pressure-sensitive (44) pressure sensor (30) whose pressure measuring element (31) is likewise inside the actuator (10),
and with a point of application (43) on the outside of the actuator (10) for manual pressure application (44),
thereby **characterized,**
**in that** the electrode (21) of the proximity sensor (20) exhibits a breakthrough (22) which is arranged between the point of application (43) on the actuator (10) and the pressure measuring element (31) of the pressure sensor (30),
and **in that** a pressure transmission element (50) transmits (45) large-area-wise an applied pressure (44) from the point of application (43) through the breakthrough (22) in the electrode (21) up to the pressure measuring element (31).

2. Device pursuant to Claim 1, thereby **characterized in that**, in relation to the point of application (43) on the actuator (10), the pressure measuring element (31) is arranged in a level beneath the breakthrough (22),
and **in that** the applied pressure (44) is further transmitted (45) by means of the pressure transmission element (50) through the breakthrough (22) up to the pressure measuring element (31) which is arranged at a distance.

3. Device pursuant to Claim 1, thereby **characterized in that** the pressure measuring element (31) is arranged in the level (60) of the breakthrough (58) provided in the electrode (57) or in a level (59) in front of the breakthrough (58), and receives a pressure activation by means of the pressure transmission element (50).

4. Device pursuant to one of the claims 1 to 3, thereby **characterized in that** the pressure transmission element envelopes a plunger (46).

5. Device pursuant to Claim 4, thereby **characterized in that** the plunger (46) sits in the zone of the point of application (43) on the inner wall (47) of the actuator (10),
and **in that** the plunger (46) is pointed through the breakthrough (22) towards the pressure measuring element (31).

6. Device pursuant to Claim 4 or 5, thereby **characterized in that** the plunger (46) is designed as a conical element (52) which with its extensive basis (53) is facing the point of application (43) on the actuator (10) and points with its conical tapering (55) toward the pressure measuring element (31).

7. Device pursuant to one of the claims 1 to 6, thereby **characterized in that** the pressure transmission element is a medium (50) which fills the space (24) between the point of application (43), the breakthrough (21) in the electrode (20) and the pressure measuring element (31).

8. Device pursuant to one of the claims 1 to 7, thereby **characterized in that** in addition to the medium (50) there is yet a further physical transmission medium.

9. Device pursuant to Claim 7 or 8, thereby **characterized in that** the medium (50) in itself is elastically resilient.

10. Device pursuant to one of the claims 7 to 9, thereby **characterized in that** the medium (50) serving to transmit (45) the pressure (44) is in itself essentially incompressible.

11. Device pursuant to one of the claims 7 to 10, thereby **characterized in that** the medium comprises a casting compound (50).

12. Device pursuant to one of the claims 7 to 11, thereby **characterized in that** the medium or the casting compound (50) essentially fills the entire acceptance (11) on the inside of the actuator (10) and guards against intruding ambient influences, like moisture.

13. Device pursuant to one of the claims 1 to 12, thereby **characterized in that** the interior of the actuator (10) has an acceptance (11) for an insert (15), and the acceptance receives the transmission medium or is enveloped by the medium or the casting compound (50),
and **in that** the insert (15) bears at least the perforated (22) electrode (21) of the proximity sensor (20) and the pressure measuring element (31) of the pressure sensor (30).

14. Device pursuant to Claim 13, thereby **characterized in that** the insert (15) accommodates at least some electrical components (41) for operation of the proximity sensor (20), the pressure sensor (30) and/or the communication medium (41), and/or contains a circuit board (40) for contacting these components (41) and/or these sensors (20, 30).

15. Device pursuant to Claim 13 or 14, thereby **characterized in that** the insert (15) has a bearing wall (19) which extends into the interior of the acceptance (11), and seated on the bearing wall (19) are both sensors (20, 30), the electrical components (41) and/or the circuit board (40).

## Revendications

1. Dispositif de déclenchement de fonctions dans un véhicule,
servant en particulier à déclencher une communication mono ou bidirectionnelle entre un transmetteur d'identification (transmetteur d'ID) dont une personne détentrice de droit se trouve en possession, et un récepteur d'identification (récepteur d'ID) agencé dans le véhicule,
lesquels entraînent, lorsque la communication réussit, l'exécution de la fonction souhaitée dans le véhicule, notamment le déverrouillage et/ou le verrouillage d'une serrure dans le véhicule,
comprenant un dispositif d'actionnement (10) sur le véhicule, lequel dispositif présente à l'intérieur de lui-même au moins deux détecteurs (20, 30) coopérant entre eux, à savoir
d'une part un détecteur de proximité (20) réagissant à l'approche d'une personne, comportant une électrode capacitive (21) à l'intérieur du dispositif d'actionnement (10), laquelle électrode génère un champ électrique dans le volume extérieur (42) du dispositif d'actionnement (10),
et d'autre part un détecteur de pression (30) réagissant à l'exercice (44) d'une pression, détecteur dont l'organe (31) mesurant la pression se trouve également à l'intérieur du dispositif d'actionnement (10),
et avec, sur le côté extérieur du dispositif d'actionnement (10), un point d'attaque (43) servant à exercer (44) manuellement une pression,
**caractérisé en ce que**
l'électrode (21) du détecteur de proximité (20) présente un orifice (22) agencé entre le point d'attaque (43) sur le dispositif d'actionnement (10) et l'organe (31) mesurant la pression qui équipe le détecteur de pression (30).
et **en ce qu'**un moyen (50) de transmission de pression traversant l'orifice (22) ménagé dans l'électrode (21) communique (45) sur une grande surface, à l'organe (31) de mesure de la pression, une pression exercée (44) depuis le point d'attaque (43).

2. Dispositif selon la revendication 1, **caractérisé en ce que** - relativement au point d'attaque (43) situé contre le moyen d'actionnement (10) - l'organe (31) de mesure de la pression se trouve sur un plan situé en dessous de l'orifice de passage (22),
et **en ce que** la pression exercée (44) est communiquée (45), par le moyen (50) de transmission de pression traversant l'orifice de passage (22), à l'organe (31) de mesure de pression agencé distant.

3. Dispositif selon la revendication 1, **caractérisé en ce que** l'organe (31) de mesure de la pression est agencé sur le plan (60) de l'orifice de passage (58) prévu dans l'électrode (57), ou sur un plan (59) en amont de l'orifice de passage (58), et qu'il reçoit via le moyen (50) de transmission une pression exercée.

4. Dispositif selon l'une des revendications 1 à 3, **caractérisé en ce que** le moyen de transmission de la pression comprend un poussoir (46).

5. Dispositif selon la revendication 4, **caractérisé en ce que** le poussoir (46) est en assise dans la zone du point d'attaque (43) contre la paroi intérieure (47) du moyen d'actionnement (10)
et **en ce que** le poussoir (46), traversant l'orifice (22), pointe en direction de l'organe (31) de mesure de la pression.

6. Dispositif selon la revendication 4 ou 5, **caractérisé en ce que** le poussoir (46) est configuré en élément conique (52) dont la base (53) à grande surface regarde le point d'attaque (43) sur le moyen d'actionnement (10), et dont le rétrécissement (55) conique pointe en direction de l'organe (31) de mesure de pression.

7. Dispositif selon l'une des revendications 1 à 6, **caractérisé en ce que** le moyen de transmission de pression est un fluide (50) remplissant l'espace (24) entre le point d'attaque (43), l'orifice de passage (21) ménagé dans l'électrode (20) et l'organe (31) de mesure de la pression.

8. Dispositif selon l'une des revendications 1 à 7, **caractérisé en ce qu'**outre le fluide (50), un autre moyen matériel de transmission entre en ligne de compte.

9. Dispositif selon la revendication 7 ou 8, **caractérisé en ce que** le fluide (50) présente intrinsèquement une mollesse élastique.

10. Dispositif selon l'une des revendications 7 à 9, **caractérisé en ce que** le fluide (50) servant à communiquer (45) la pression (44) est pour l'essentiel intrinsèquement incompressible.

11. Dispositif selon l'une des revendications 7 à 10, **caractérisé en ce que** le fluide se compose d'une pâte de remplissage (50).

12. Dispositif selon l'une des revendications 7 à 11, **caractérisé en ce que** le fluide ou la pâte de remplissage (50) comble pour l'essentiel l'intégralité du réceptacle (11)
à l'intérieur du moyen d'actionnement (10) et protège contre la pénétration de facteurs environnementaux tels que l'humidité.

13. Dispositif selon l'une des revendications 1 à 12, **caractérisé en ce que** l'intérieur du moyen d'actionnement (10) est muni d'un réceptacle (11) pour insert (15), réceptacle qui reçoit le moyen de transmission ou qui est enveloppé par le fluide ou par la pâte de remplissage (50),
et **en ce que** l'insert (15) porte au moins l'électrode (21) perforée (22) du détecteur de proximité (20), et l'organe (31) de mesure de force afférent au détecteur de pression (30).

14. Dispositif selon la revendication 13, **caractérisé en ce que** l'insert (15) reçoit au moins quelques composants (41) électriques permettant l'exploitation du détecteur de proximité (20), du détecteur de pression (30), et/ou les moyens de communication (41), et/ou contient une carte (40) servant à établir le contact avec ces composants (41) et/ou ces détecteurs (20, 30).

15. Dispositif selon la revendication 13 ou 14, **caractérisé en ce que** l'insert (15) comporte une paroi porteuse (19) qui s'étend à l'intérieur du réceptacle (11) et **en ce que** les deux détecteurs (20, 30), les composants électriques (41) et/ou la platine (40) reposent contre la paroi porteuse (19).
